# EUROPÄISCHE PATENTSCHRIFT

(11) **EP 2 279 534 B1**
(45) Veröffentlichungstag und Bekanntmachung des Hinweises auf die Patenterteilung: **19.10.2016**
(21) Anmeldenummer: 09737852.5
(22) Anmeldetag: 24.04.2009
(51) Int. Cl.: H01L 33/48, H01L 33/62, H01L 33/32, H01L 33/00

(54) **LED-ELEMENT MIT DÜNNSCHICHT-HALBLEITERBAUELEMENT AUF GALLIUMNITRID-BASIS**
LED ELEMENT WITH A THIN-LAYER SEMICONDUCTOR ELEMENT MADE OF GALLIUM NITRIDE
ÉLÉMENT DE DEL COMPRENANT UN COMPOSANT SEMI-CONDUCTEUR EN COUCHE MINCE À BASE DE NITRURE DE GALLIUM

(30) Priorität: 30.04.2008 DE 102008021659
(43) Veröffentlichungstag der Anmeldung: 02.02.2011
(73) Patentinhaber: Tridonic Jennersdorf GmbH, 8380 Jennersdorf (AT)
(72) Erfinder: TASCH, Stefan, A-8380 Jennersdorf (AT)
(74) Vertreter: Rupp, Christian
(86) Internationale Anmeldenummer: PCT/EP2009/003026
(87) Internationale Veröffentlichungsnummer: WO 2009/132808

(56) Entgegenhaltungen:
- EP-A- 1 605 523
- EP-A- 1 848 042
- EP-A- 1 876 653
- US-A1- 2006 027 826
- US-A1- 2006 240 585
- US-A1- 2007 221 936
- US-B1- 6 531 328
- SCHANG-JING HON; CHENG TA KUO; CHEN T P; HSIEH M H: "High-power GaN LED chip with low thermal resistance", PROCEEDINGS OF THE SPIE - THE INTERNATIONAL SOCIETY FOR OPTICAL ENGINEERING, vol. 6894, 7 February 2008 (2008-02-07), pages 68941-1-10, XP040434077, USA DOI: 10.1117/12.768595

## Beschreibung

Die vorliegende Erfindung betrifft ein LED-Element, aufweisend ein Dünnschicht-Halbleiterbauelement ("Chip") auf Galliumnitrid-Basis, welches auf einer Siliziumplattform angeordnet ist, die auf einer dem Halbleiterbauelement abgewandten Seite Elektroden aufweist, welche elektrisch mit dem Halbleiterbauelement verbunden sind.

### Hintergrund der Erfindung

Herkömmliche strahlungsemittierende Halbleiterbauelemente bestehen im Allgemeinen aus einem Trägersubstrat und einer darauf epitaktisch aufgewachsenen Mehrschichtstruktur, welche eine aktive strahlungserzeugende Schicht aufweist. Dabei ist das Trägersubstrat vorzugsweise elektrisch leitfähig, um einen vertikalen Stromfluss durch das Halbleiterbauelement zu ermöglichen. In vielen Anwendungsfällen ist es zudem wünschenswert, dass das Trägersubstrat für die von der aktiven Schicht emittierte Strahlung transparent ist. Hierbei ist jedoch zu beachten, dass die Transparenz der Substratschicht bezüglich der emittierten Strahlung der aktiven Schicht des Halbleiterbauelements oftmals im Widerspruch zu der gewünschten elektrischen Leitfähigkeit des Trägersubstrats steht. Für Leuchtdioden auf Galliumnitrid-Basis kann beispielsweise Saphir (Al₂O₃) als Material für das Trägersubstrat verwendet werden, welches für blaues Licht transparent, aber nicht elektrisch leitfähig ist. Aus diesem Grund wird oftmals Silizium-Karbid (SiC) als Trägersubstrat für Leuchtdioden auf Galliumnitrid-Basis verwendet, da es sowohl eine hohe Transparenz als auch eine hohe elektrische Leitfähigkeit aufweist. Kennzeichnend für das Material Silizium-Karbid als Trägersubstrat ist jedoch, dass dessen Transparenz mit erhöhter Leitfähigkeit abnimmt.

Um die Effektivität von Leuchtdioden weiter zu verbessern wurden sogenannte Dünnschicht-Halbleiterbauelemente entwickelt. Dabei handelt es sich um Halbleiterbauelemente, bei welchen die Substratschicht für das Kristallwachstum genutzt, nach diesem Prozess jedoch entfernt wird. Die daraus resultierende dünne Schicht ermöglicht eine effektivere Lichtemission als bei herkömmlichen Technologien, da keine Substratschicht vorhanden ist, welche einen Teil der Lichtemission absorbiert. Dies führt zudem zu einer verbesserten Wärmeabfuhr.

Zur Entfernung der Substratschicht wird im Allgemeinen ein chemischer oder physikalischer Prozess angewandt. Beispielsweise kann durch das sogenannte Laser-Lift-Off-Verfahren das Licht eines gepulsten UV-Lasers zur Abtragung der Substratschicht verwendet werden, ohne dass dabei die bspw. 5 µm dicke Galliumnitridschicht zerstört wird.

Aus der US20060240585A1 ist eine geschichtete Struktur (p-, n- und aktive Schichten) mit einer Dicke von 3µm bekannt. Hinsichtlich des Aufbaus eines strahlungsemittierenden Bauelementes auf GaN-Basis, d.h. mit einem epitaktisch gewachsenen Stapel an GaN-Schichten, wir ausdrücklich zur Vermeidung von Wiederholungen auf diese Schrift verwiesen.

Strahlungsemittierende Bauelemente auf GaN-Basis sind beispielsweise aus US 5,874,747 bekannt.

WO 2006/065046 beschreibt ein Verfahren zur Herstellung eines Dünnschicht-Halbleiterbauelements auf Galliumnitrid Basis. Dabei wird zum Entfernen der Saphir-Substratschicht, auf welcher die Kristallstruktur der LED gewachsen ist, ein sog. Laser-Lift-Off-Verfahren angewendet. Vor dem Entfernen der Substratschicht wird die Kristallstruktur auf einer zusätzlichen Substratschicht aufgebracht. Anschließend erfolgt in einem weiteren Verfahrensschritt eine Aufspaltung in einheitliche LED Chips.

Aus der DE10056475 ist bekannt ein strahlungsemittierendes Halbleiterbauelement auf GaN-Basis mit einem Halbleiterkörper, der ein SiC-basierendes Substrat aufweist, auf das eine Mehrzahl GaN-basierender Schichten aufgebracht ist, wobei diese Mehrzahl mindestens einen aktiven Bereich enthält, der zwischen mindestens einer n-leitenden Schicht und mindestens einer p-leitenden Schicht angeordnet ist, dadurch gekennzeichnet, dass die p-leitende Schicht zugverspannt aufgewachsen ist.

Aus Haerle et.al. "High brightness LEDs for general lighting applications Using the new ThinGaN™-Technology", physica status solidi (a), Volume 201, Issue 12 , Pages 2736 - 2739, ist grundsätzlich die Anwendung der dünnen GaN-Technologie im Bereich leistungsfähiger LEDs bekannt.

Der Artikel SCHANG-JING HON et al "High-power GaN LED chip with low thermal resistance", PROCEEDINGS OF THE SPIE, Bd. 6894, 7. Februar 2008, offenbart ein LED-Modul, mit einem GaN Dünnschicht-LED-Chip, wobei die Gesamtdicke der epitaktischen Galliumnitrid-Schichten des LED-Chips zwischen 1 und 10 µm beträgt. Der LED-Chip ist auf einem AlN- oder Siliziumsubstrat angeordnet.

US 2007/221936 offenbart einen Dünnschicht-Leuchtdioden-Chip, der auf einer Plattform mit einer Kavität angeordnet ist. Dieser LED-Chip weist eine Dicke von 25 µm auf.

US 6 531 328 offenbart ein LED-Modul mit einem GaN-LED-Chip, der auf einer Siliziumplattform angeordnet ist. Die Siliziumplattform weist eine Kavität auf, in welcher der LED-Chip angeordnet ist, und hat zwei Durchkontaktierungen, die den LED-Chip in elektrischer Verbindung mit zwei Elektroden auf der Rückseite bringen.

Aufbauend auf diesem Stand der Technik liegt der vorliegenden Erfindung die Aufgabe zugrunde, ein LED-Element bereitzustellen, welches ein Dünnschicht-Halbleiterbauelement auf Galliumnitrid-Basis aufweist, wobei das LED Modul gegenüber dem Stand der Technik verbesserte thermische Eigenschaften und einen kompaktere Bauweise aufweist.

Halbleiterbauelemente ("Chips") auf Galliumnitrid-Basis werden bevorzugt zur Erzeugung von Strahlung im blaugrünen Spektralbereich verwendet. Neben Galliumnitrid (GaN) werden im Rahmen der vorliegenden Erfindung unter einem GaN-basierenden Material alle mit GaN verwandten oder abgeleiteten Mischkristalle verstanden. Hierzu zählen insbesondere die Materialien Galliumnitrid (GaN), Inidumnitrid (InN) und Aluminiumnitrid (AlN).

### Ziel und Zusammenfassung der Erfindung

Die Erfindung wird in den unabhängigen Ansprüchen definiert. Vorteilhafte Weiterbildungen der Erfindung sind in den zugehörigen abhängigen Ansprüchen angegeben.

Die Erfindung behandelt ein LED-Modul aufweisend wenigstens einen LED-Chip, aufweisend eine aktive Galliumnitrid-Schicht, und eine Siliziumplattform, auf welcher der LED-Chip angeordnet ist, wobei die Siliziumplattform auf einer dem LED-Chip abgewandten Seite zwei Elektroden aufweist, welche mit dem LED-Chip in elektrischer Verbindung stehen, und wobei die Gesamtdicke der übereinanderliegenden epitaktischen Galliumnitrid-Schichten (n-und p-type, aktive GaN-Schicht) des LED-Chips zwischen 2 und 10 µm, vorzugsweise 2 bis 5 µm beträgt.

Die Siliziumplattform weist eine Kavität auf, in welcher der LED-Chip angeordnet ist (alternativ kann ein den LED-Chip umgebender Rahmen auf der Siliziumplattform separat oder integriert vorgesehen sein). Der LED-Chip ist dabei vorzugsweise mittig in der Kavität angeordnet. Zudem ist der LED-Chip in einer zuvor definierten Distanz zum Rand der Kavität angeordnet. Die Kavität ist vorzugweise quadratisch oder kreisförmig ausgeführt. Sie kann jedoch auch eine andere Form aufweisen. Die Kavität kann beispielsweise auch ellipsenförmig oder dreieckig sein.

Die GaN-Schichten gemäss der Erfindung weisen auf von GaN abgeleitete oder mit GaN verwandte Materialien sowie darauf aufbauende ternäre oder quaternäre Mischkristalle. Veispile dafür sind AlN, InN, AlGaN (Al1-xGaxN, 0 </= x </= 1), InGaN (In1-xGaxN, 0 </= x </= 1), InAlN (In1-xAlxN, 0 </= x </= 1) und AlInGaN (Al1-x-yInxGayN, 0 </= x </= 1, 0 </= y </= 1).

Die Erzeugung des Dünnschicht-Halbleiterbauelements, welches eine Galliumnitrid-Schicht aufweist, erfolgt dabei vorzugsweise durch ein Laser-Lift-Off-Verfahren oder ein anderes Verfahren, welches geeignet ist, die Galliumnitridschicht von der Substratschicht zu trennen. Die Galliumnitridschicht ist vorzugsweise auf einer Saphir- oder Silizium-Karbid Substratschicht gewachsen und durch das oben beschriebene Verfahren frei von Substrat.

Der erfindungsgemäße LED-Chip ist vorzugsweise durch Bond-Drähte oder mittels Flip-Chip Technologie auf der Siliziumplattform aufgebracht. Der LED-Chip kann daher in "Face-Up" oder in "Face-Down"-Position auf der Siliziumplattform angeordnet sein.

Die Elektroden sind auf der Unterseite der Siliziumplattform angeordnet. Dies ermöglicht eine einfachere elektrische Anbindung des LED-Moduls an eine Stromquelle oder Steuerung.

Die Siliziumplattform des erfindungsgemäßen LED-Moduls weist vorzugsweise Durchkontaktierungen auf, welche die Elektroden auf der Unterseite der Siliziumplattform mit Elektroden des LED Chips elektrisch verbinden. Die Durchkontaktierungen erstrecken sich dabei vorzugsweise von einer ersten Seite der Siliziumplattform zu einer zweiten Seite der Plattform. Die Querschnittsform der Bohrungen ist vorzugsweise radial und weist einen Durchmesser von 0,1 - 0,5 mm auf. Ferner sind die Bohrungen vorzugsweise mit elektrisch leitfähigem Material, beispielsweise Kupfer, Gold gefüllt. Es wird explizit darauf hingewiesen, dass die Durchkontaktierungen auch eine andere Querschnittsform, beispielsweise eine quadratische Form aufweisen können. Die Erzeugung der Durchkontaktierungen in der Siliziumplattform kann beispielsweise durch Trocken- oder Nassätzung erfolgen.

Die epitaktische LED-GaN-Schichten (n-, p- und aktive Schichten) sind direkt auf der Oberfläche der Siliziumplattform angeordnet. Dies bedeutet, es befinden sich keine weiteren Zwischenschichten (oder Substrat) zwischen der Galliumnitrid-Schicht des LED-Chips und der Siliziumplattform. Die Oberfläche der Siliziumplattform ist dabei vorzugsweise größer als die Oberfläche des LED-Chips, welche mit der Siliziumplattform in Kontakt steht. Des Weiteren erstreckt sich die Siliziumplattform vorzugsweise seitlich über den LED-Chip hinaus. Durch diese Anordnung werden insbesondere die thermischen Eigenschaften des LED-Moduls deutlich verbessert. Es ist somit eine verbesserte Wärmeabfuhr vom LED-Chip möglich. Zusätzlich kann die Baugröße des LED-Chips reduziert werden.

Der LED-Chip ist mit den Durchkontaktierungen der Siliziumplattform vorzugsweise mittels flächigen Kontakten oder sogenannten "Bumps" elektrisch verbunden. Die flächigen Kontakte haben dabei den Vorteil einer besseren Wärmeabfuhr. Es ist jedoch auch möglich, den GaN-Chip und die Siliziumplatte (Siliziumplattform) mit Hilfe von Bond-Drähten elektrisch zu verbinden.

Die Kavität kann wenigstens teilweise mit einer Farbkonversionsschicht gefüllt sein. Die Farbkonversionsschicht besteht dabei vorzugsweise aus einem flüssigen, aushärtbaren und optisch transparenten Material, welches Phosphorpartikel als Leuchtstoff enthält. Als Leuchtstoff kann beispielsweise ein BOSE oder YAG-Phosphor verwendet werden. Die Farbkonversionsschicht bedeckt den in der Kavität angeordneten LED-Chip vorzugsweise ohne Gaseinschlüsse.

Das Volumen der Kavität kann bündig bis zur Oberfläche der Siliziumplattform mit einer Farbkonversionsschicht gefüllt sein. Dabei wird die anfangs flüssige Farbkonversionsschicht vorzugsweise mit Hilfe eines Dispensvorgangs in die Kavität gefüllt. Auf diese Art kann selbstverständlich auch eine Streuschicht in die Kavität gefüllt werden. Die durch eine derartige Vorgehensweise aufgebrachten Schichten können nacheinander oder gleichzeitig ausgehärtet werden. Hierbei bedeutet ein Aushärten der Schichten nacheinander, dass zuerst eine erste Schicht dispensiert wird, welche in einem darauf folgenden Aushärtevorgang wärmebehandelt wird, bevor eine weitere Schicht auf dieser ersten Schicht mittels Dispensvorgang aufgebracht wird. Ein gleichzeitiges Aushärten bedeutet, dass die einzelnen Farbkonversions- und/oder Streuschichten zunächst zeitlich versetzt aufeinander aufgebracht werden und anschließend in einem einzigen Aushärtevorgang gemeinsam wärmebehandelt werden.

Auch vorgeformte Farbkonversionselelemente mit Leuchtstoff und/oder Streupartikeln können aufgebracht werden.

Es ist zudem möglich, eine Lichtscheibe oder Linse oberhalb des LED-Chips anzuordnen. Dabei kann Farbkonversionsmittel in dieser Lichtscheibe dispergiert sein.

Das erfindungsgemäße LED-Modul weist im Vergleich zu den herkömmlichen LED-Modulen kompaktere Abmessungen auf. Weitere Vorteile sind ein höherer Wirkungsgrad und eine bessere Wärmeabfuhr ("Thermomanagement").

Speziell weist die Siliziumplattform vorzugsweise eine Dicke auf, welche weniger als 500 µm beträgt. Die Dicke der Siliziumplattform unterhalb einer darin geformten Kavität beträgt vorzugsweise weniger als 300 µm.

Die Abmessungen der Länge und Breite der Siliziumplattform betragen vorzugsweise zwischen 1,0 und 6,5 mm. Dabei ist eine Länge bzw. Breite der Siliziumplattform zwischen 1 und 2,5 mm besonders bevorzugt.

In einem Ausführungsbeispiel, das nicht Teil der Erfindung ist, ist der LED-Chip auf einer zusätzlichen Siliziumsubstratschicht angeordnet, wobei die Siliziumsubstratschicht und der darauf angeordnete LED-Chip identische Abmessungen bezüglich deren Länge und Breite aufweisen. In Draufsicht verdeckt die Kontur des LED-Chips demnach die Siliziumsubstratschicht. Vorzugsweise weist die Länge und Breite der Siliziumsubstratschicht hierbei einen Wert zwischen 1 und 3 mm auf.

Die erfindungsgemässen LED-Chips mit Si und GaN können gut assembliert wurden und die dabei entstehenden Wafer können in der gleichen Weise wie bekannte LED-Chips vereinzelt warden.

### Kurzbeschreibung der Zeichnungen

Ein bevorzugtes Ausführungsbeispiel des erfindungsgemäßen LED-Moduls ist in den Zeichnungen darstellt und wird in der nachfolgenden Beschreibung näher erläutert.
Fig. 1 zeigt eine seitliche Schnittansicht eines Ausführungsbeispiels eines nicht erfindungsgemäßen LED-Moduls, wobei die Galliumnitridschicht des LED-Chips direkt auf der Siliziumplattform angeordnet ist.
Fig. 2 zeigt ein weiteres bevorzugtes Ausführungsbeispiel des erfindungsgemäßen LED-Moduls, wobei die Siliziumplattform eine Kavität aufweist, in welcher der LED-Chip angeordnet ist.
Fig. 3 zeigt ein weiteres Ausführungsbeispiel eines nicht erfindungsgemäßen LED-Moduls, wobei die Galliumnitridschicht des LED-Chips auf einem zusätzlichen Siliziumsubstrat aufgebracht ist, welche auf der Oberfläche der Siliziumplattform angeordnet ist.
Fig. 4 zeigt ein weiteres Ausführungsbeispiel eines nicht erfindungsgemäßen LED-Moduls nach Figur 3, wobei zwei Farbkonversionsschichten oberhalb des LED-Chips aufgebracht sind.
Fig. 5 zeigt ein bevorzugtes Ausführungsbeispiel eines erfindungsgemäßen LED-Moduls in Draufsicht.

### Genaue Beschreibung der Ausführungen

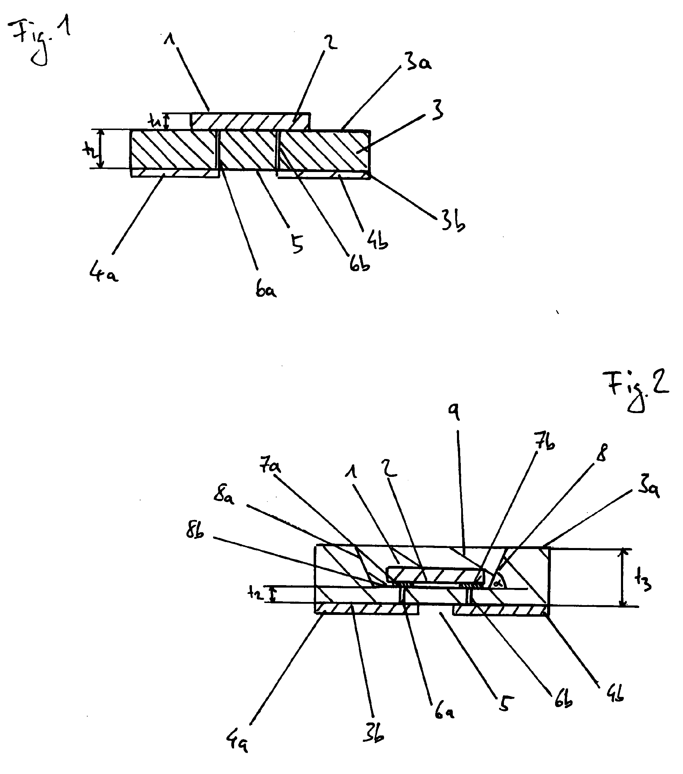

Figur 1 zeigt in einer seitlichen Schnittansicht ein Ausführungsbeispiel eines nicht erfindungsgemäßen LED-Moduls. Der LED-Chip 1 ist ein Chip, welcher im Wesentlichen mehrere epitaktische Galliumnitridschichten 2 aufweist und auf einer Plattform 3 angeordnet ist.

Unter "Galliumnitridschicht" ist eine Schicht auf GaN-Basis oder auf Basis eines zu GaN verwandten oder davon abgeleiteten Mischkristalls zu verstehen, also bspw. auch Indiumnitrid (InN) und Aluminiumnitrid (AlN).

Vorzugsweise stellen diese epitaktischen Galliumnitridschichten 2 alle epitaktischen Schichten des LED-Chips dar.

Die Plattform ist erfindungsgemäß aus Silizium. Selbstverständlich können auf der Siliziumplattform 3 auch mehrere LED-Chips 1 angeordnet sein.

Die Dicke t₂ der Siliziumplattform 3 beträgt erfindungsgemäß zwischen 100 und 500 µm. Die Gesamtdicke t₁ der Galliumnitridschichten 2 (und somit die Gesamtdicke sämtlicher epitaktischen Schichten) des wenigstens einen LED-Chips 1 beträgt erfindungsgemäß zwischen 1 und 10 µm, vorzugsweise zwischen 1 und 5 µm.

Die Siliziumplattform 3 weist eine Oberseite 3a und eine Unterseite 3b auf. Der LED-Chip 1 ist vorzugsweise auf der Oberseite 3a angeordnet. Auf der Unterseite 3b der Siliziumplattform 3, und damit auf einer dem LED-Chip abgewandten Seite, befinden sich zwei Elektroden 4a,4b. Die Elektroden 4a, 4b sind vorzugsweise flächige Kontakte. Ein Luftspalt zwischen den Elektroden stellt die elektrische Isolierung dar. Die Grösse der Elektroden ist bpsw. 200µm mal 200µm.

Die Siliziumplattform 3 weist vorzugsweise Durchkontaktierungen 6a, 6b auf, welche die Elektroden 4a, 4b mit dem LED-Chip 1 elektrisch verbinden. Die Durchkontaktierungen 6a, 6b bzw. flächigen Kontakte (4a, 4b) werden auf ein elektrisch (mit Oxid- oder Nitridschicht)isoliertes Si-Plättchen aufgebracht.

Figur 2 zeigt ein bevorzugtes Ausführungsbeispiel der vorliegenden Erfindung. In diesem Ausführungsbeispiel weist die Siliziumplattform 3 eine Kavität 8 auf, in welcher der LED-Chip 1 angeordnet ist. Der LED-Chip ist dabei vorzugsweise mittig in der Kavität 8 angeordnet. Die Siliziumplattform 3 in diesem Ausführungsbeispiel weist eine Dicke t₃ zwischen 400 und 700 µm auf. Die Dicke t₂ der Siliziumplattform 3 unterhalb des LED-Chips 1 beträgt erfindungsgemäß zwischen 50 und 300 µm.

Die Kavität 8 weist eine ebene Grundfläche 8b auf, welche sich parallel zur Oberfläche 3a der Siliziumplattform 3 erstreckt. Eine Seitenfläche 8a der Kavität 8 verbindet die Grundfläche 8b mit der Oberfläche 3a der Siliziumplattform 3. Die Kavität 8 ist vorzugsweise kreisförmig oder rechtwinklig ausgeführt. Die Seitenfläche 8a kann bezüglich der Oberfläche 3a der Siliziumplattform in einem beliebigen Winkel α zwischen 1 und 90° geneigt sein. Vorzugsweise beträgt der Wert des Winkels α zwischen 45 und 90°. Die Seitenfläche 8a und die Grundfläche 8b weisen vorzugsweise eine reflektierende Oberfläche auf. Diese kann reguläre oder diffuse Reflexion erzeugen. Dementsprechend kann die Lichtausbeute des LED-Moduls gesteigert werden.

Wie in Figur 2 dargestellt, ist der LED-Chip 1 mit Hilfe von Kontaktflächen bzw. Kontaktschichten 7a, 7b und Durchkontaktierungen 6a, 6b mit den Elektroden 4a, 4b elektrisch verbunden. Die Kontaktschichten 7a, 7b sind vorzugsweise aus Goldzinn (AuSn), welches eine thermische Leitfähigkeit von 57 W/m-K aufweist. Dadurch kann eine optimale Wärmeabfuhr vom LED-Chip 1 zur Siliziumplattform 3 erzielt werden. Es können auch sogenannte Bumps als Kontaktflächen verwendet werden.

Die Kavität 8 des LED-Moduls ist mit mindestens einer Farbkonversionsschicht 9 gefüllt, welche den LED-Chip 1 ohne Gaseinschluss abdeckt. In der Farbkonversionsschicht 9 sind vorzugsweise Phosphorpartikel dispergiert, um eine Farbkonversion der von dem LED-Chip 1 emittierten Strahlung zu ermöglichen. Wie in Figur 2 dargestellt, ist die Farbkonversionsschicht 9 vorzugsweise bündig mit der Oberfläche 3a der Siliziumplattform ausgeführt. Es ist jedoch auch möglich, dass die Farbkonversionsschicht 9 das Volumen der Kavität 8 nur teilweise ausfüllt. Die Oberfläche der Farbkonversionsschicht 9 kann eben, konkav oder konvex ausgeführt sein.

Auf der Farbkonversionsschicht 9 kann eine Schicht mit Streupartikeln angeordnet sein. Diese kann dispensed oder als Formteil aufgebracht sein.

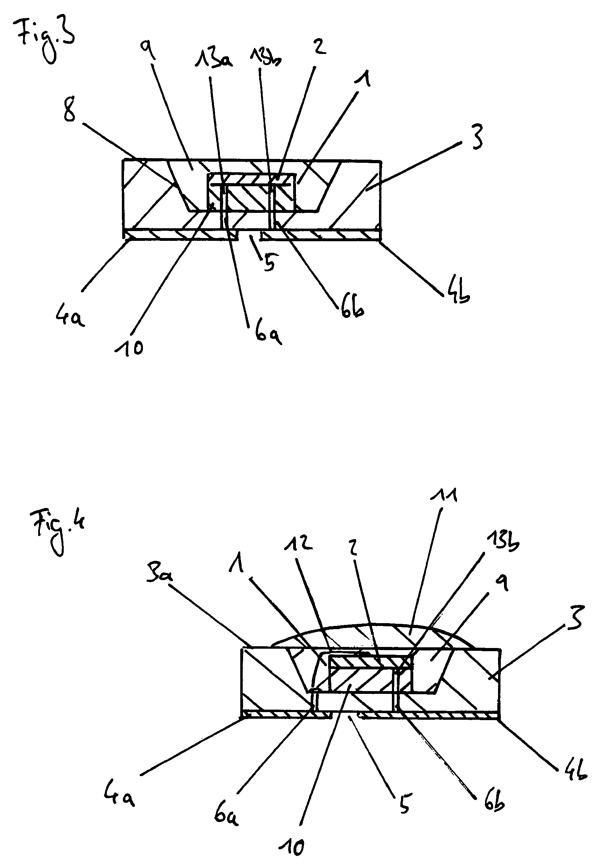

Figur 3 zeigt eine seitliche Schnittansicht einer Ausführungsform eines nicht erfindungsgemäßen LED-Moduls. Bei dieser Ausführungsform ist die aktive Galliumnitridschicht, die nur eine der mehreren GaN-Schichten 2 darstellt, auf einer zusätzlichen Substratschicht 10 angeordnet, welche vorzugsweise aus Silizium besteht. Diese Substratschicht 10 befindet sich demnach zwischen den Galliumnitridschichten 2 und der Siliziumplattform 3. Dies hat den produktionstechnischen Vorteil, dass die assemblierten Si- und GaN-Schichten leicht getrennt und als Wafer gehandhabt werden können.

Die Siliziumsubstratschicht 10 ist dabei auf der Oberfläche 3a der Siliziumplattform 3 angeordnet. Die Siliziumsubstratschicht 10 weist vorzugsweise Durchkontaktierungen 13a, 13b auf, welche die aktive Galliumnitridschicht 2 mit den Durchkontaktierungen 6a,6b der Siliziumplattform 3 elektrisch verbinden. Die Durchkontaktierungen 13a, 13b der Siliziumsubstratschicht 10 weisen vorzugsweise den gleichen Querschnitt wie die Durchkontaktierungen 6a, 6b auf. Die Siliziumsubstratschicht 10 weist vorzugsweise eine Dicke von 50-100 µm auf.

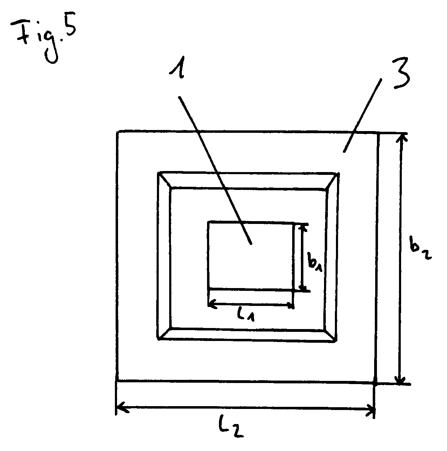

Die Siliziumsubstratschicht 10 weist vorzugsweise dieselben Abmessungen wie die Galliumnitridschichten 2 bezüglich deren Länge l₁ und Breite b₁ (siehe Figur 5) auf. Dies bedeutet, dass die Konturen der Galliumnitridschichten 2 in Draufsicht die Siliziumsubstratschicht 10 vorzugsweise überdecken. Es ist jedoch zu erwähnen, dass die Abmessungen der Länge l₁ und Breite b₁ der Siliziumsubstratschicht 10 und der Galliumnitridschichten 2 um bis zu 10 % voneinander abweichen können. Dies bedeutet, dass die Oberfläche der Siliziumsubstratschicht 10, auf der die Galliumnitritschichten 2 aufgebracht ist um bis zu 10 % größer sein kann.

Die Substratschicht 10 wird vorzugsweise auf die Galliumnitridschicht 2 aufgebracht, bevor die anfängliche Substratschicht, bestehend aus Silizium-Karbid oder Saphir, auf welcher die epitaktischen Galliumnitrid-Schichten 2 epitaktisch gewachsen sind, entfernt wird.

Es ist zu erwähnen, dass die Anzahl der Durchkontaktierungen 6a, 6b, 13a, 13b nicht auf eine bestimmte Menge begrenzt ist. Vielmehr kann eine Vielzahl von Durchkontaktierungen 6a, 6b, 13a, 13b in der Substratschicht 10 und der Siliziumplattform 3 angeordnet sein, um eine elektrische Verbindung zwischen den Elektroden 4a, 4b und dem LED-Chip 1 herzustellen.

In Figur 4 ist ein weiteres Ausführungsbeispiel eines nicht erfindungsgemäßen LED-Moduls dargestellt. Wie bereits mit Bezug auf Figur 3 beschrieben, sind die epitaktische LED-Schichten auf GaN-Basis auf einer Siliziumsubstratschicht 10 angeordnet. In diesem Ausführungsbeispiel weist das LED-Modul wenigstens einen Bonddraht 12 auf, welcher den LED-Chip 1 mit wenigstens einer Durchkontaktierung 6a der Siliziumplattform 3 verbindet. Das Siliziumsubstrat 10 weist in diesem Ausführungsbeispiel eine oder mehrere Durchkontaktierung 13b auf, welche mit nur einer Elektrode 4b des LED-Moduls elektrisch verbunden sind.

Wie in Figur 4 ersichtlich, kann die Größe der beiden Elektroden 4a, 4b voneinander abweichen. Dies kann für die Wärmeabfuhr vom LED-Chip 1 von Vorteil sein.

Wie in Figur 4 dargestellt, sind eine Farbkonversionsschicht und eine Streuschicht 9,11 auf dem LED-Chip 1 angeordnet. Hierbei ist die erste Schicht 9 vorzugsweise parallel mit der Oberfläche 3a der Siliziumplattform 3 ausgeformt. Die Streuschicht 11 ist oberhalb der ersten Schicht 9 mit Hilfe eines sog. Dispens-Verfahrens aufgebracht. Die Oberfläche der Streuschicht 11 ist vorzugsweise konvex. Der Durchmesser der zweiten Farbkonversionsschicht 11 ist vorzugsweise größer als der Durchmesser der Kavität 8. Auf diese Weise wird die gesamte, von der Oberfläche der ersten Farbkonversionsschicht 9 emittierte Strahlung durch die Streuschicht 11 transmittiert. Die Streuschicht kann in geringer Konzentration auch Streupartikel aufweisen.

Die Konzentration von Farbkonversionsmittel innerhalb der Farbkonversions- und Streuschichten 9,11 kann voneinander abweichen.

Figur 5 zeigt eine Draufsicht auf ein erfindungsgemäßes LED-Modul. Dabei weist die Länge l₁ und die Breite b₁ des LED-Chip 1 typischerweise einen Wert zwischen 0,5 - 1,5 mm auf. Die Länge l₂ und die Breite b₂ der Siliziumplattform liegt zwischen 1,0 und 6,5 mm. Vorzugsweise weist die Siliziumplattform ein Wert zwischen 1 und 2,5 mm auf.

## Patentansprüche

1. LED-Modul, aufweisend einen LED-Chip (1) mit mehreren unmittelbar übereinander liegenden epitaktischen Galliumnitrid-Schichten (2) und eine Siliziumplattform (3), auf welcher der LED-Chip (1) angeordnet ist,
wobei die Galliumnitrid-Schichten wenigstens eine n-dotierte Schicht, eine aktive Schicht und eine p-dotierte Schicht aufweisen,
wobei die Siliziumplattform (3) auf einer dem LED-Chip (1) abgewandten Seite (3b) zwei Elektroden (4a, 4b) aufweist, welche mit dem LED-Chip (1) in elektrischer Verbindung stehen, und
wobei die Gesamtdicke der epitaktischen Galliumnitrid-Schichten (2) des LED-Chips (1) zwischen 1 und 10 µm, vorzugsweise 2 bis 5 µm beträgt,
wobei die Siliziumplattform (3) eine Kavität (8) aufweist, in welcher der LED-Chip (1) angeordnet ist,
und
wobei die epitaktischen Galliumnitrid-Schichten direkt auf einer Oberfläche (3a) der Siliziumplattform (3) angeordnet sind, und wobei der LED-Chip neben den epitaktischen Galliumnitrid-Schichten keine weiteren Substratschichten aufweist.

2. LED-Modul nach Anspruch 1,
wobei die Siliziumplattform (3)
Durchkontaktierungen (6a, 6b) aufweist, welche die Elektroden (4a, 4b) der Siliziumplattform (3) mit dem LED-Chip (1) elektrisch verbinden.

3. LED Modul nach Anspruch 1 oder 2,
wobei der LED-Chip (1) mit den
Durchkontaktierungen (4a, 4b) der Siliziumplattform (3) mittels Bumps oder flächigen Kontakten (7a, 7b) elektrisch verbunden ist.

4. LED-Modul nach einem der vorhergehenden Ansprüche,
wobei die Kavität (8) der Siliziumplattform (3) mit einer Farbkonversionsschicht (9) und/oder einer Schicht mit Streupartikeln gefüllt ist.

5. LED-Modul nach einem der vorhergehenden Ansprüche,
wobei die Dicke (t₂) der Siliziumplattform (3) unterhalb des LED-Chips (1) weniger als 300 µm beträgt.

6. LED-Modul nach einem der vorhergehenden Ansprüche,
wobei die Länge (l₁) und Breite (b₁) der Siliziumplattform zwischen 2,5 und 6,5 mm beträgt.

7. LED-Modul nach einem der vorhergehenden Ansprüche,
wobei der LED-Chip (1) in Face-Up oder Face-Down Position auf der Siliziumplattform (3) angeordnet ist.

## Claims

1. LED module comprising an LED chip (1) having a plurality of directly overlying epitaxial gallium nitride layers (2) and a silicon platform (3) on which the LED chip (1) is arranged,
wherein the gallium nitride layers comprise at least one n-doped layer, an active layer and a p-doped layer,
wherein the silicon platform (3) comprises two electrodes (4a, 4b) on one of the sides (3b) facing away from the LED chip (1), and which are in electrical communication with the LED chip (1), and
wherein the total thickness of the epitaxial gallium nitride layers (2) of the LED chip (1) is 1-10 µm, preferably 2-5 µm,
wherein the silicon platform (3) has a cavity (8) in which the LED chip (1) is arranged, and
wherein the epitaxial gallium nitride layers are arranged directly on a surface (3a) of the silicon platform (3), and
wherein the LED chip has no further substrate layers in addition to the epitaxial gallium nitride layers.

2. LED module according to claim 1,
wherein the silicon platform (3) comprises through-connections (6a, 6b) which electrically connect the electrodes (4a, 4b) of the silicon platform (3) with the LED chip (1).

3. LED module according to claim 1 or 2,
wherein the LED chip (1) is electrically connected with the through-connections (4a, 4b) of the silicon platform (3) by means of bumps or flat contacts (7a, 7b).

4. LED module according to one of the preceding claims,
wherein the cavity (8) of the silicon platform (3) is filled with a color conversion layer (9) and/or a layer with scattered particles.

5. LED module according to one of the preceding claims,
wherein the thickness (t₂) of the silicon platform (3) below the LED chip (1) is less than 300 µm.

6. LED module according to one of the preceding claims,
wherein the length (l₁) and width (b₁) of the silicon platform is from 2.5 to 6.5 mm.

7. LED module according to one of the preceding claims,
wherein the LED chip (1) is arranged in a face-up or face-down position on the silicon platform (3).

## Revendications

1. Module à LED comprenant une puce à LED (1) avec plusieurs couches de nitrure de gallium épitaxiales (2) directement superposées et une plate-forme de silicium (3), sur laquelle la puce à LED (1) est disposée,
les couches de nitrure de gallium comprenant au moins une couche dopée n, une couche active et une couche dopée p,
la plate-forme de silicium (3) comprenant, sur un côté (3b) opposé à la puce à LED (1), deux électrodes (4a, 4b), qui sont reliées électriquement avec la puce à LED (1) et l'épaisseur totale des couches de nitrure de gallium épitaxiales (2) de la puce à LED (1) étant de 1 à 10 µm, de préférence de 2 à 5 µm,
la plate-forme de silicium (3) comprenant une cavité (8) dans laquelle la puce à LED (1) est disposée, et
les couches de nitrure de gallium épitaxiales (2) étant disposées directement sur une surface (3a) de la plate-forme de silicium (3) et la puce à LED ne comprenant, en plus des couches de nitrure de gallium épitaxiales, aucune couche de substrat supplémentaire.

2. Module à LED selon la revendication 1,
la plate-forme de silicium (3) comprenant des contacts d'interconnexion (6a, 6b) qui relient électriquement les électrodes (4a, 4b) de la plate-forme de silicium (3) avec la puce à LED (1).

3. Module à LED selon la revendication 1 ou 2,
la puce à LED (1) étant reliée électriquement avec les contacts d'interconnexion (6a, 6b) de la plate-forme de silicium (3) au moyen de bosses ou de contacts plats (7a, 7b).

4. Module à LED selon l'une des revendications précédentes,
la cavité (8) de la plate-forme de silicium (3) est remplie avec une couche de conversion de couleur (9) et/ou une couche avec des particules de diffusion.

5. Module à LED selon l'une des revendications précédentes,
l'épaisseur (t₂) de la plate-forme de silicium (3) en dessous de la puce à LED (1) étant inférieure à 300 µm.

6. Module à LED selon l'une des revendications précédentes,
la longueur (l1) et la largeur (b1) de la plate-forme de silicium sont de 2,5 à 6,5 mm.

7. Module à LED selon l'une des revendications précédentes,
la puce à LED (1) est disposée sur la plate-forme de silicium (3) face vers le haut ou face vers le bas.
